# EUROPEAN PATENT APPLICATION

(11) **EP 1 976 116 A1**
(43) Date of publication of application: **01.10.2008**
(21) Application number: 07445012.3
(22) Date of filing: 29.03.2007
(51) Int. Cl.: H03H 9/64

(54) **An antenna arrangement for a portable radio communication device**

(71) Applicant: Laird Technologies AB, 184 25 Åkersberga (SE)
(72) Inventor: Winter, James Blake, Lincoln, Nebraska 68506 (US); Kaikkonen, Andrei, 164 71 Kista (SE); Lindberg, Peter, 752 29 Uppsala (SE)
(74) Representative: Fritzon, Rolf

(57) **Abstract**

The present invention relates to an antenna arrangement for receiving signals compatible with the Digital Video Broadcasting Handheld standard. The antenna arrangement comprises an antenna radiator (7), a filter (6) and a preamplifier (8), wherein the filter (6) is connected to the antenna radiator (7) and to the preamplifier (8). The filter (8) is an acoustic filter device having at least five terminals, which filter (8) is arranged to reject GSM signals received through the antenna radiator (7). The antenna arrangement comprises a first inductance means (L1) connected to a first terminal (1) of the filter (6) and to the antenna radiator (7), a second inductance means (L2) connected to a second terminal (2) of the filter (6) and to a third terminal (3) of the filter (6), and a third inductance means (L3) connected to a fourth terminal (4) of the filter (6) and to the preamplifier (8), and a fifth terminal (5) of the filter is grounded.

## Description

### FIELD OF INVENTION

The present invention relates generally to antennas, and particularly to an antenna arrangement for the Digital Video Broadcasting Handheld (DVB-H) standard.

### BACKGROUND

Portable radio communication devices, such as mobile phones, are presently utilized a lot. As users most of their time carry a portable radio communication device with them it is desirable to have as many functions as possible gathered in such a device. However, the size of a portable radio communication device, to be really portable, should be kept as small as possible. This is many times contrary to the desire of gathering as many functions as possible in such a device.

One desired additional function, and sometimes used function, in a mobile phone, or the like, is a television receiver, which received broadcasted signals through a standard called Digital Video Broadcasting Handheld (DVB-H). A DVB-H receiver is arranged to receive signals between 470 and 750 MHz. This provides a problem in a mobile phone e.g. having a GSM transmitting frequency between 880 and 915 MHz for GSM900 and between 1710 and 1990 for GSM1800, since the energy in the transmitted signals easily is picked up by a DVB-H antenna in the mobile phone, which picked up energy saturates the DVB-H receiver. When the DVB-H receiver, or rather its preamplifier, is saturated by GSM signals it will not be able to correctly receive DVB-H signals. To cover the whole frequency band for DVB-H an antenna arrangement for DVB-H of the mobile phone need to have a very broad bandwidth, and still have the possibility to reject GSM900 or GSM1800 signals transmitted close in frequency and distance.

In order for a DVB-H receiver to work properly in a mobile phone signals received from a DVB-H antenna should not be attenuated more than 2 dB. Also, for GSM900 signal not to saturate the DVB-H receiver such signals should be attenuated at least 40 dB. Further, if the mobile phone has multi-band telephone coverage e.g. GSM1800 signals should be attenuated at least 35 dB.

### SUMMARY OF THE INVENTION

An object of the present invention is to provide an antenna arrangement that can receive signals compatible with the DVB-H standard and that at the same time can reject GSM signals.

This object, among others, is according to the present invention attained by an antenna arrangement and a portable radio communication device, respectively, as defined by the appended claims.

By providing an antenna arrangement for receiving signals compatible with the Digital Video Broadcasting Handheld (DVB-H) standard with an antenna radiator, a preamplifier, and an acoustic filter device having at least five terminals GSM signals can be rejected at the same time as DVB-H signals are received. Three inductance means are used in the antenna arrangement to tune the acoustic filter device to desired properties.

The inductances of the three inductance means are preferably realized by means of lumped components, but could alternatively also be realized by means of transmission/microstrip lines.

The acoustic filter device is preferably a SAW filter device. Preferably, the acoustic filter device has an attenuation of at most 2 dB for 470-750 MHz to pass DVB-H signals. Further, the acoustic filter device preferably has an attenuation of at least 40 dB for 880-915 MHz, to reject GSM900 transmission signals, the acoustic filter device preferably also has an attenuation of at least 35 dB for 1710-1990 MHz to reject GSM1800 transmission signals.

An inductance means connected between the antenna radiator and the acoustic filter device is preferably changeable between at least two different values, to allow changeable impedance values of the antenna radiator. This is preferably provided by means of a MEMS switch.

Further features and advantages of the present invention will be evident from the following description.

### BRIEF DESCRIPTION OF THE DRAWINGS

The present invention will become more fully understood from the detailed description of embodiments given below and the accompanying figures, which are given by way of illustration only, and thus, are not limitative of the present invention, wherein:
Fig. 1 schematically shows a SAW filter having five terminals;
Fig. 2 schematically shows an antenna arrangement according to the present invention; and
Fig. 3 illustrates measurement of impedance for different parts of an antenna arrangement according to the present invention.

### DETAILED DESCRIPTION OF EMBODIMENTS

In the following description, for purpose of explanation and not limitation, specific details are set forth, such as particular techniques and applications in order to provide a thorough understanding of the present invention. However, it will be apparent for a person skilled in the art that the present invention may be practiced in other embodiments that depart from these specific details. In other instances, detailed description of well-known methods and apparatuses are omitted so as not to obscure the description of the present invention with unnecessary details.

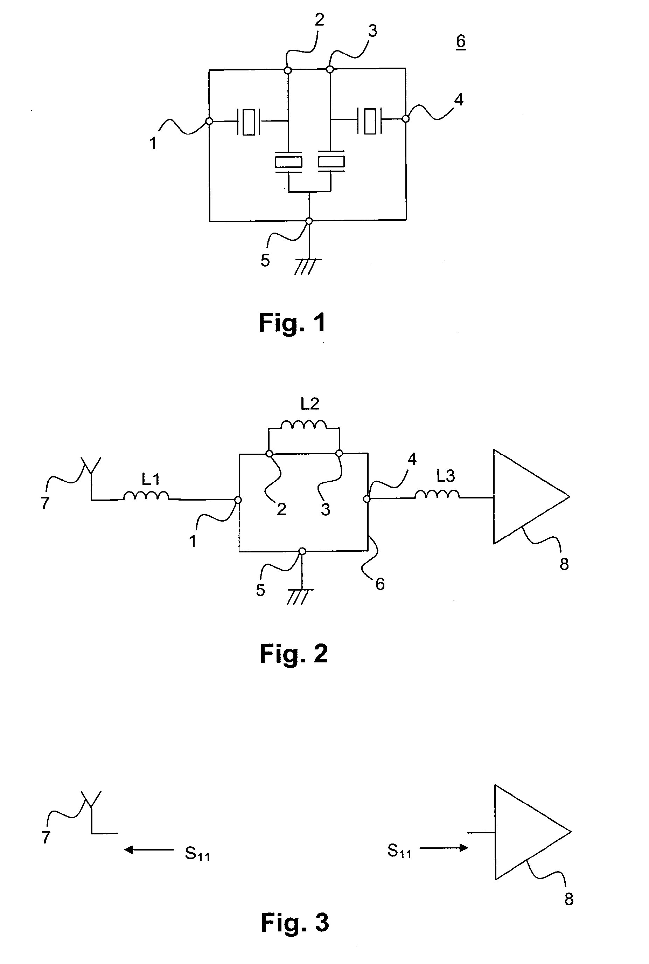

A first embodiment of the present invention will now be described with reference to Figs. 1-3.

A portable radio communication device, such as a mobile phone, portable computer, Personal Digital Assistant or similar, comprises a DVB-H (Digital Video Broadcasting - Handheld) antenna arrangement for receiving television signals. The antenna arrangement comprises an antenna radiator 7, an acoustic filter device 6 and a preamplifier 8, which together commonly is called an active antenna. The antenna radiator 7 is arranged to receive DVB-H signals, which preferably is provided by means of a monopole or other kind of antenna radiator, which antenna radiator generally has an impedance differing from a traditional 50 Ω. The preamplifier 8 is arranged to pre-amplify DVB-H signals and generally has an impedance differing from a traditional 50 Ω. The acoustic filter device 6 is provided to reject GSM signal, and has at least five terminals 1-5. The acoustic filter device 6 comprises a plurality of resonators coupled to the terminals 1-5 such that a multi-pole filter function is provided having very steep filter functions. The acoustic filter device is preferably a SAW (Surface Acoustic Wave) filter, but could alternatively be e.g. a BAW (Bulk Acoustic Wave) or FBAR (Film Bulk Acoustic Resonator) filter.

The antenna arrangement further comprises three inductance means L1-L3, which preferably are lumped components but could alternatively be realized by means of e.g. transmission/microstrip lines. The first inductance means L1 is connected between a first terminal 1 of the acoustic filter device 6 and the antenna radiator 7. The second inductance means L2 is connected between a second terminal 2 and a third terminal 3 of the acoustic filter device 6. The third inductance means L3 is connected between a fourth terminal 4 of the acoustic filter device 6 and the preamplifier 8. A fifth terminal 5 of the acoustic filter device 6 is grounded.

To determine the values of the impedance means L1-L3 the following procedure is followed. The S₁₁ parameter for the antenna radiator 7 is measured, and the S₁₁ parameter for the preamplifier 8 is also measured. The transfer function for the acoustic filter device 6 is e.g. taken from manufacturer information. The function |S₂₁|, which is a function for the antenna arrangement comprising the measured impedance of the antenna element 7, the given transfer function of the acoustic filter 6, the measured impedance of the preamplifier 8 and the unknown values of the inductance means L1-L3, is used together with the following three conditions
|S₂₁| > -2 dB, for 470-750 MHz
|S₂₁| < -40 dB, for 880-915 MHz
|S₂₁| < -35 dB, for 1710-1990 MHz
to determined the values of L1-L3.

Further, one advanced way to achieve a broad bandwidth of the antenna radiator, in order to receive the whole bandwidth of DVB-H, is to switch between two or more different configurations of the antenna radiator. The impedance of the antenna radiator will in such a case vary for the different configurations. In order to still have the acoustic filter device reject GSM signals and pass DVB-H signals essentially only L1 will need to be changed in dependence on the different impedances of the antenna radiator. A MEMS switch can e.g. be used to select different inductance values for L1, in dependence on different impedance values of the antenna radiator.

It will be obvious that the present invention may be varied in a plurality of ways. Such variations are not to be regarded as departure from the scope of the present invention as defined by the appended claims. All such variations as would be obvious for a person skilled in the art are intended to be included within the scope of the present invention as defined by the appended claims.

## Claims

1. An antenna arrangement for receiving signals compatible with the Digital Video Broadcasting Handheld standard, said antenna arrangement comprising an antenna radiator (7), a filter (6) and a preamplifier (8), wherein said filter (6) is connected to said antenna radiator (7) and to said preamplifier (8), **characterized in that**
- said filter (8) is an acoustic filter device having at least five terminals, which filter (8) is arranged to reject GSM signals received through said antenna radiator (7),
- said antenna radiator has an impedance differing from 50 Ω, and said preamplifier has an impedance differing from 50 Ω,
- said antenna arrangement comprises a first inductance means (L1) connected to a first terminal (1) of said filter (6) and to said antenna radiator (7), a second inductance means (L2) connected to a second terminal (2) of said filter (6) and to a third terminal (3) of said filter (6), and a third inductance means (L3) connected to a fourth terminal (4) of said filter (6) and to said preamplifier (8), and
- a fifth terminal (5) of said filter is grounded.

2. The antenna arrangement according to claim 1, wherein said first (L1), second (L2) and third (L3) inductance comprises lumped components or transmission/microstrip lines.

3. The antenna arrangement according to claim 1 or 2, wherein said acoustic filter device (6) is a SAW filter device.

4. The antenna arrangement according to any of claims 1-3, wherein said acoustic filter device (6) has an attenuation of at most 2 dB for 470-750 MHz.

5. The antenna arrangement according to any of claims 1-4, wherein said acoustic filter device (6) has an attenuation of at least 40 dB for 880-915 MHz.

6. The antenna arrangement according to any of claims 1-5, wherein said acoustic filter device (6) has an attenuation of at least 35 dB for 1710-1990 MHz.

7. The antenna arrangement according to any of claims 1-6, wherein said first inductance means (L1) is changeable between at least two different values.

8. The antenna arrangement according to claim 7, comprising a MEMS switch to change said first inductances means (L1) between its values.

9. A portable radio communication device comprising an antenna arrangement according to any previous claim and a GSM antenna arrangement for receiving and transmitting GSM signals.

10. A method of determining inductance values for the antenna arrangement according to any of claims 1-8, comprising the following steps:
- measuring the impedance of the antenna radiator (7),
- measuring the impedance of the preamplifier (8),
- retrieving the transfer function of the acoustic filter device (6),
- determining the inductance values of the first, second and third inductance means (L1-L3) based on the following conditions:
|S₂₁| > -2 dB, for 470-750 MHz
|S₂₁| < -40 dB, for 880-915 MHz
|S₂₁| < -35 dB, for 1710-1990 MHz
